(19) Europäisches Patentamt

European Patent Office

Office européen des brevets

(11) **EP 4 087 374 A1**

(12) **EUROPEAN PATENT APPLICATION**

(43) Date of publication:
**09.11.2022 Bulletin 2022/45**

(21) Application number: **22164202.8**

(22) Date of filing: **24.03.2022**

(51) International Patent Classification (IPC):
***H05K 1/03*** *(2006.01)*     ***H01L 23/498*** *(2006.01)*
***H01L 23/15*** *(2006.01)*

(52) Cooperative Patent Classification (CPC):
**H01L 23/49822; H01L 23/15; H05K 3/007;**
H01L 23/5389; H05K 3/284; H05K 2203/016;
H05K 2203/0228; H05K 2203/1327

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **26.03.2021 CN 202110331646**

(71) Applicant: **AT&S (Chongqing) Company Limited
Chongqing 401133 (CN)**

(72) Inventor: **Lee, Minwoo
Chongqing (CN)**

(74) Representative: **Dilg, Haeusler, Schindelmann
Patentanwaltsgesellschaft mbH
Leonrodstraße 58
80636 München (DE)**

(54) **HYBRID CORE AND METHOD OF MANUFACTURING COMPONENT CARRIERS USING A HYBRID CORE**

(57)     A method of manufacturing a component carrier (101) comprises: (i) embedding at least one carrier plate (120) in a core (111); (ii) forming a stack (102) on the at least one carrier plate (120), wherein the stack (102) comprises at least one electrically conductive layer structure (103) and/or at least one electrically insulating layer structure (104); (iii) thereafter removing the at least one carrier plate (120) from the stack (102). A corresponding hybrid core (110) and a corresponding semi-finished product (100) each comprise analogous features.

Fig. 1

EP 4 087 374 A1

**Description**

Technical Field

The present invention generally relates to the technical field of component carriers as mechanical support structures for electronic components and for electrically contacting electronic components. Specifically, the present invention relates to methods of manufacturing component carriers using hybrid cores as well as to hybrid cores and semifinished products comprising hybrid cores.

Background

Ongoing miniaturization in the production of component carriers in combination with increasing electronic functionality leads to the need for novel manufacturing approaches. In recent years, various processing steps have been increasingly realized in terms of panel level packaging (PLP). This development can be viewed as merging embedded die technologies on the level of printed wiring boards (PWB) with fan-out wafer level packaging (FOWLP) on the wafer level. Using larger, mostly rectangular panels can increase productivity and reduce costs in comparison with conventional wafer processing. However, issues such as warpage or manufacturing reliability become more pressing due to the larger size of the panels. One avenue to address these problems is by means of using innovative materials in the manufacturing process of component carriers.

Thus, there may be a need for efficient manufacturing processes of component carriers, which enable high yield while at the same time ensuring reliability and reducing costs.

Summary of the Invention

This need may be met by the subject matter according to the independent claims. Advantageous embodiments of the present invention are described by the dependent claims.

According to an aspect of the invention, a method of manufacturing a component carrier comprises: (i) embedding at least one carrier plate in a core, in particular to form a hybrid core; (ii) forming a stack, in particular a stack of the component carrier, on the at least one carrier plate, wherein the stack comprises at least one electrically conductive layer structure and/or at least one electrically insulating layer structure; (iii) thereafter removing the at least one carrier plate from the stack.

According to a further aspect of the invention, a hybrid core for manufacturing a component carrier comprises: (i) a core; and (ii) at least one carrier plate embedded in the core, wherein the at least one carrier plate is configured so that a stack comprising at least one electrically conductive layer structure and/or at least one electrically insulating layer structure, in particular a stack of the component carrier, can be formed on the at least one carrier plate.

According to a further aspect of the invention, a semifinished product for manufacturing a component carrier comprises: (i) a core; (ii) at least one carrier plate embedded in the core; and (iii) a stack, in particular a stack of the component carrier, on the at least one carrier plate, wherein the stack comprises at least one electrically conductive layer structure and/or at least one electrically insulating layer structure.

In the context of the present application, the term "component carrier" may denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers. The component carrier may be an interposer. The component carrier may be or comprise one or more redistribution layers. In particular, the component carrier may be a fan-out module. Such a fan-out module may be configured for enlarging the footprint of a component attached to the component carrier.

The component carrier may comprise a "stack" of at least one electrically insulating layer structure and/or at least one electrically conductive layer structure. The stack may consist of a single layer structure or it may comprise a plurality of layer structures. For example, the component carrier may be a laminate of the mentioned electrically insulating layer structure(s) and electrically conductive layer structure(s), in particular formed by applying mechanical pressure and/or thermal energy. An insulating layer structure of the stack may for example be an epoxy-based build-up film layer structure such as an Ajinomoto Build-up Film (ABF) layer structure, a photo-imageable dielectric (PID) layer structure, a glass cloth primer (GCP) layer structure, a prepreg layer structure or a solder resist (SR) layer structure. An electrically conductive layer structure may be a metal layer structure, in particular a copper layer structure such as a structured or non-structured copper foil.

The mentioned stack may provide a plate-shaped component carrier capable of providing a large mounting surface for further components and being nevertheless very thin and compact. The stack may be thinner than 500 $\mu$m,

in particular thinner than 200 μm. Accordingly, the insulating layer structures may all be thinner than 50 μm. More than one component carrier may be formed from the stack on the at least one carrier plate. Only part of the stack may form part of the finished component carrier.

The term "layer structure" may denote a continuous layer, a patterned layer or a plurality of non-consecutive islands within a common plane. The different layer structures are stacked on top of each other in a "stacking direction". The stacking direction of the component carrier or stack may be parallel to the surface normal of the main surfaces of the layer structures and/or the main surfaces of the stack. A "main surface" of a layer, layer structure or stack may be either one of those two surfaces, which have the largest extension compared with the other surfaces. The main surface may be defined as a surface perpendicular to the stacking direction. A "side surface" of a layer, layer structure or stack may be any external surface, which is not a main surface. A side surface may be any external surface which is perpendicular to a main surface and/or which extends along the stacking direction. A "vertical direction" may be defined with respect to a given stack as being parallel to the stacking direction. A "horizontal direction" may be defined with respect to a given stack as any direction perpendicular to the stacking direction. The extension along the horizontal plane of a layer structure, in particular along any direction of the horizontal plane, may be larger than the extension of the layer structure in vertical direction, in particular at least five times as large, in particular at least twenty times as large, in particular at least a hundred times as large. One or both main surfaces of a layer structure may or may not be flat.

A "component" may be an electronic component, which may be any physical entity forming part of an electronic system. An electronic component may have one or more electrical terminals or leads, configured for electrically contacting the electronic component. It may comprise one or more electronic circuits which may be configured to implement a particular function or subfunction of the component, in particular in the context of the electronic system. A component may itself comprise one or more subcomponents being themselves components. It may comprise a carrier for mechanical stabilization of the component, as a support structure for different parts of the component and/or for electrically connecting different parts of the component. A component may comprise a housing and/or encapsulation protecting the component from external influences, e.g. mechanical or electromagnetic influences. A component may be an active, passive or electromechanical component.

The component may be surface mounted to the stack, e.g. at a top or bottom surface of the stack with respect to the stacking direction or at a side surface of the stack with respect to the stacking direction. The component may be at least partly, in particular fully, embedded in the component carrier. It may be arranged in a recess or a cavity of the component carrier. When embedded, the entire surface of the component may be in contact with the stack, or at least parts of the surface of the component may not be in contact with the stack. The component may be separated from the stack by a gap which may be defined by the cavity or recess, in which the component is arranged.

In the context of the present application, the term "core" may denote any rigid structure with the help of which a component carrier can be formed. It may be a rigid structure on which one or more layer structures of a component carrier are formed, in particular a stack of the component carrier. The core may or may not form part of the finished component carrier. The core may be a sacrificial structure, which is used only for manufacturing the component carrier, but is eventually discarded. Fiducials may be positioned on the core, in particular on an outer frame of the core.

The core may comprise several core portions. These core portions may be connected with each other or they may form disconnected parts of the core. The core may be formed as a frame comprising a plurality of ridges, which are connected to each other. The core may comprise an outer frame surrounding, in particular completely surrounding, the at least one carrier plate and/or it may comprise one or more ridges connecting different portions of the outer frame. The core may be configured to provide mechanical stability, in particular when it is formed as a frame. The core may comprise one or more recesses or cavities, in particular one or more through-holes and/or one or more blind-holes. Such recesses or cavities may for example be formed by routing.

The core may be or comprise a layered structure comprising several layer structures or layers. The core may comprise one or more insulating layer structures. One or more of these insulating layer structure may be hardened and/or cured. One or more of them may comprise resin, in particular a hardened or cured resin. One or more of them may comprise a reinforcing element, in particular fibers, in particular interwoven glass fibers. The reinforcing element may be impregnated with resin. An insulating layer structure may comprise any typical core material, in particular FR-4, which may be defined as a composite material comprising woven fiberglass cloth impregnated with an epoxy resin. In addition or alternatively, the core may comprise one or more electrically conductive layer structures. In particular, it may comprise two electrically conductive layer structures as outermost layer structures, in particular copper layers, e.g. copper foils.

The core may consist of a core base layer, which may in particular be an insulating layer, with a respective core metal layer attached to both main surfaces of the core base layer. The core metal layers may be electrically conductive layer structures, in particular copper layers or copper foils. The core base layer may be thicker than a core metal layer, in particular more than twice as thick, in particular more than ten times as thick, in particular more than a hundred times as thick.

The core or a part of the core may or may not form part of a stack of a component carrier. A stacking direction of the core may or may not correspond to the stacking direction of the stack. Main surfaces, side surfaces, vertical direction and horizontal direction may be defined for the core in an analogous way as for the stack. The core may be arranged such that a main surface of the core is parallel to a main surface of the stack. The core may be arranged such that a main surface of the core is adjacent to or touches a main surface of the stack.

The core may be prefabricated to be used in the production of component carriers. It may have been prefabricated in a location different from the location where the component carriers are manufactured. The core may be a prefabricated basis, which is provided to form layers of a component carrier thereon.

A "carrier plate" may similarly denote a rigid structure with the help of which a component carrier can be formed. The carrier plate may be a core or may form part of a core. The carrier plate may comprise one or more materials, from which cores are typically formed such as FR-4 and/or copper. The carrier plate may comprise the same or similar materials as the core. The carrier plate may comprise materials different from the materials of the core. The layered structure of the core may be similar to a layered structure of the carrier plate, e.g. may comprise the same number of layers, or the layered structures may differ from each other.

The carrier plate may or may not be plate-shaped. It may be substantially flat. The extension of the carrier plate in horizontal dimensions may be much larger than its extension in the vertical dimension, in particular more than five times as large, in particular more than twenty times as large, in particular more than a hundred times as large. The thickness of the carrier plate may be defined as its extension in the vertical dimension. A profile of the carrier plate may be defined as its outline in the horizontal plane. The profile or outline of the carrier plate may have any geometrical form, e.g. circular, oval, triangular, rectangular, trapezoidal, quadratic, or n-angular.

At least part of the profile of the carrier plate may be complementary to at least part of a profile of the core. For example, the core may comprise through-holes and/or blind holes, within which corresponding carrier plates can be arranged. All carrier plates embedded in the core may have the same profile, the same area and/or the same thickness. Different carrier plates of different profiles and/or of different thicknesses may be embedded in the core. The thickness of the carrier plate may be the same as the thickness of the core, or it may differ by at most 50 percent, in particular at most 10 percent, in particular at most 5 percent. The thickness of the carrier plate may be smaller than the thickness of the core or it may be larger.

The carrier plate may be a rigid structure on which one or more layer structures of a component carrier are formed, in particular a stack of the component carrier. The carrier plate may or may not form part of the finished component carrier. The carrier plate may be a sacrificial structure, which is used only for manufacturing the component carrier and which is eventually discarded. One or more component carriers, e.g. component carrier units, may be formed on a single carrier plate. Component carriers may be formed only on the at least one carrier plate, but not on the core.

The carrier plate may be or comprise a layered structure comprising several layer structures or layers. The carrier plate may comprise one or more insulating layer structures. One or more of these insulating layer structures may comprise or consist of at least one of a glass, a ceramic, and a plastic. One or more of these insulating layer structure may be hardened and/or cured. One or more of them may comprise resin, in particular a hardened or cured resin. One or more of them may comprise a reinforcing element such as interwoven fibers. An insulating layer structure of the carrier plate may comprise any typical core material such as FR-4, which may be defined as a composite material comprising woven fiberglass cloth impregnated with an epoxy resin. In addition or alternatively, the carrier plate may comprise one or more electrically conductive layer structures. In particular, it may comprise a conductive layer structure on the side of the carrier plate, on which the stack and/or component carrier is to be formed, in particular a metal foil. It may comprise a conductive layer structure only on this side of the carrier plate, but not on the opposite side.

The carrier plate may comprise a base layer, which may in particular be an insulating layer, with a metal layer arranged on at least one main surface of the base layer. The base layer may comprise or consist of at least one of a glass, a ceramic, and a plastic. The metal layer may be arranged directly on the main surface of the base layer or there may be one or more additional layers in between. The metal layer may or may not be an outermost layer of the carrier plate. The metal layer may be an electrically conductive layer structure, in particular a copper layer or a copper foil. The base layer may be thicker than the metal layer, in particular more than twice as thick, in particular more than ten times as thick, in particular more than a hundred times as thick. The thickness of the metal layer may be less than 1 $\mu$m, in particular less than 0.5 $\mu$m.

The carrier plate or a part of the carrier plate may or may not form part of a stack of a component carrier. A stacking direction of the carrier plate may or may not correspond to the stacking direction of the stack and/or the core. Main surfaces, side surfaces, vertical direction and horizontal direction may be defined for the carrier plate in an analogous way as for the stack and/or the core. The carrier plate may be arranged such that a main surface of the carrier plate is parallel to a main surface of the stack. The carrier plate may be arranged such that a main surface of the carrier plate is adjacent to or touches a main surface of the stack. The carrier plate may be arranged such that a side surface of the carrier plate is adjacent to or touches a side surface of the core, in particular an inner side surface of the core.

The carrier plate may be prefabricated to be used in the production of component carriers. It may have been prefabricated in a location different from the location, where the component carriers are manufactured. The carrier plate may be a prefabricated basis, which is provided to form one or more layers of a component carrier thereon.

"Forming" a stack on the at least one carrier plate may comprise simultaneously forming the stack on at least parts of the core, into which the carrier plate is embedded. The stack may be formed continuously on at least parts of the core and on at least parts of the at least one carrier plate. Forming the stack may comprise forming the stack directly on the carrier plate or forming the stack on a main surface of the hybrid core under which the carrier plate is embedded. In other words, one or more layer structures may be arranged between stack and embedded carrier plate. For example, an adhesive layer may be arranged between carrier plate and stack. The adhesive layer may be configured to adhere or bond the carrier plate to the core. Alternatively or in addition, the adhesive layer may be configured to adhere or bond the stack to the carrier plate and/or core.

"Embedding" a carrier plate in a core may refer to any process, by which the carrier plate is arranged at least partially, in particularly completely, within the core and/or by which the carrier plate and the core are fixed to each other. They may be fixed to each other by an adhesive material, which may or may not form part of the core and/or the carrier plate. The adhesive material may be separate from both carrier plate and core. The adhesive material may be arranged between the carrier plate and the core, in particular only there, and it may cover further sides of the core and/or the carrier plate, e.g. a main surface of the core and/or of the carrier plate. The adhesive material may be or comprise a curable resin. The carrier plate and the core may be attached or fixed to each other, when the adhesive material is cured.

Before attaching the carrier plate to the core, the carrier plate and/or the core may be placed on a further carrier, e.g. a carrier tape. When the carrier plate is arranged with respect to the core, in particular within the core, a small gap may remain between carrier plate and core. The adhesive material may be dispensed and/or injected into the gap between core and carrier plate. Alternatively or in addition, the adhesive material may result from a sheet of adhesive material being applied to the core and/or the carrier plate, in particular laminated thereon. When being applied, the adhesive material of the sheet may fill a gap between core and carrier plate.

Embedding the carrier plate may refer to any process, by which the carrier plate and the core are arranged next to each other, in particular such that a main surface of the carrier plate is aligned with a main surface of the core. The carrier plate and the core may be arranged laterally with respect to each other, e.g. so that a side surface of the carrier plate is arranged opposite a corresponding side surface of the core. The carrier plate may be arranged in a cavity of the core, in particular a through-hole or a blind hole. The carrier plate may be fully arranged in the cavity or only part of the carrier plate may be arranged in the cavity. Part of the carrier plate may protrude from the cavity.

By embedding the carrier plate in the core, a "hybrid core" may be formed. The hybrid core may serve as a rigid structure, on which one or more layer structures of a component carrier can be formed. A hybrid core may be a core with an inhomogeneous composition, in particular with materially different regions along the horizontal plane. A hybrid core may be defined as a core with at least one carrier plate being at least partly arranged and/or at least partly embedded therein.

"Removing" the carrier plate may refer to any process, by which the carrier plate is separated from the stack. The carrier plate may be removed at a release layer and/or at a detachable interface. Only part of the carrier plate may be removed, while another part may remain attached to the stack and/or may form part of the stack and/or finished component carrier. When removing the carrier plate, a base layer of the carrier plate may be removed. When removing the carrier plate, a seed layer of the carrier plate may or may not be removed. When removing the carrier plate, the core may also be removed from the stack.

Removing the carrier plate may be a two-step process, in which first the core is removed, e.g. by routing, and second the carrier plate is removed from the stack. When the hybrid core is a panel configured for manufacturing a plurality of component carriers, the panel may be separated into a plurality of panel portions, when the core is removed. Each panel portion may comprise a single component carrier or an array of component carriers. The component carriers of the array may be singulated before or after the carrier plate has been removed.

An advantage of the above-described method of manufacturing a component carrier, of the corresponding hybrid core, and of the semifinished product for manufacturing a component carrier may be that the core together with the carrier plate form a hybrid core, on which stacks of component carriers can be efficiently manufactured. Such a hybrid core may allow for a wider range of materials to be used for the core. For example, a hybrid core may allow for combining different materials the properties of which adequately complement each other, e.g. one material providing a smooth surface and another material providing stability, e.g. preventing breakage of the hybrid core. In this way, warpage during manufacture of the component carriers may be reduced and/or reliability and yield may be increased.

Furthermore, by using a hybrid core, standard or conventional substrate processes may be used for forming a stack, in particular for forming the stack on materials like glass, on which such standard or conventional substrate process may otherwise not be applicable. Some materials like glass may provide an especially smooth and/or flat surface, which may allow forming a stack with high precision and with an especially fine structure, e.g. with especially small dimensions of lines, spaces and/or vias, for example lines and spaces smaller than 5 μm.

By removing the carrier plate from the stack, in particular by using the carrier plate as a sacrificial structure providing stability during the manufacturing process, especially thin stacks can be formed, e.g. especially thin redistribution layers, especially thin substrates or especially thin interposers. When electrically connected to a component, such thin stacks can for example function as redistribution layers. For example, these stacks may serve as fan-out modules enlarging the footprint of a component. This may allow for efficiently connecting components having a particularly dense arrangement of electrical contacts and thus may contribute to further miniaturization of electronic packages comprising component carriers and components.

According to an embodiment of the invention, a plurality of carrier plates are embedded in the core. For example, two, three, four, five, more than five, more than ten, or even more than a hundred carrier plates may be embedded in the core. The carrier plates may all have the same size or they may differ in size. They may all have the same form or they may differ in form. They may all have the same thickness or they may differ in thickness. The size, form, and/or thickness of the carrier plates may be determined by the material of the carrier plate, e.g. by its stability or reliability depending on the size and/or thickness of the carrier plate, in particular by its tendency to break. The plurality of carrier plates may be formed so that they cover most of the area of a panel, in particular more than 50 percent, in particular more than 90 percent. As an example, four carrier plates of equal size, in particular four rectangular carrier plates, may be arranged to form a larger rectangle.

The above-described embodiment may be advantageous because using a plurality of carrier plates may add stability to a hybrid core compared with using just a single carrier plate. The size of each carrier plate may be restricted in order to facilitate the handling of carrier plates and/or to avoid breakage of carrier plates.

According to an exemplary embodiment, the carrier plate has a size smaller than 100 square inch or equivalently 0.065 square meter. This may prevent the carrier plate from breaking, e.g. if it comprises glass.

According to an exemplary embodiment, only a single carrier plate is embedded in the core. Such an embodiment may be advantageous because a corresponding hybrid core may be particularly simple and cheap to manufacture.

According to a further embodiment of the invention, two carrier plates of the plurality of carrier plates are separated by a portion of the core. The portion of the core may be or comprise one or more ridges. Such ridges may connect parts of an outer frame of the core. The width of a ridge may be much smaller than the length of the ridge, in particular smaller than a fifth of the length, in particular smaller than a tenth of the length. Width and length may extend in a horizontal direction.

The above-described embodiment may be advantageous because such portions of the core may add structural stability to the hybrid core.

According to a further embodiment of the invention, the at least one carrier plate is attached to the core by an adhesive. In the context of this application, an "adhesive" may be any material configured to attach different objects to each other. The adhesive may form part of the hybrid carrier. The adhesive may be or comprise a resin, in particular a curable resin.

The adhesive may be applied in liquid form and be subsequently cured. It may be injected in a gap between carrier plate and core and be cured in that gap. The adhesive may be or comprise an adhesive resin. It may be or comprise at least one of an epoxy adhesive, a mold resin and an engineering plastic.

Alternatively or in addition, the adhesive may be applied as part of a layer or a sheet, with which at least portions of the carrier plate and the core are covered. The sheet may be molded, for example by applying pressure and/or heat. When molded, the adhesive may at least partly fill a gap between carrier plate and core. The sheet may be laminated on the carrier plate and/or the core. It may at least partly encapsulate the carrier plate and/or the core. The sheet may consist of or comprise at least one of a mold film, a glass cloth prepreg (GCP), an epoxy-based build-up film such as an Ajinomoto Bond Film or Ajinomoto Build-up Film (ABF), an Ajinomoto Bond Film - Glass Cloth Prepreg (ABF-GCP), a prepreg layer (PPG), a photo-imageable dielectric (PID) and a solder resist dry film (SRDF) layer.

Using an adhesive to attach the carrier plate to the core may be advantageous, because such an adhesive may be applicable by widely used standard techniques such as injection or lamination. The adhesive may contribute to the mechanical stability of the hybrid carrier.

According to a further embodiment of the invention, the core and the at least one carrier plate form part of a panel, by means of which a plurality of component carriers can be manufactured, in particular be manufactured simultaneously.

In the context of the present application, a "panel" may be any materially continuous carrier used in the manufacture of a plurality of component carriers, in particular of component carriers of the same or similar design, but possibly also component carriers of different design. The panel may form part of the finished component carriers or it may be a sacrificial structure, which is eventually discarded. During manufacture, the component carriers may be separated from each other, e.g. in a depaneling step. The separation may result from at least one of breaking, punching, routing, sawing, and cutting, in particular laser cutting.

Alternatively or in addition, the term "panel" may refer to a plurality of stacks and/or a plurality of component carriers, when they are connected to each other. In a panel, the plurality of component carriers, a corresponding plurality of preforms of component carriers and/or a corresponding plurality of carrier structures for the component carriers may be arranged as an array. Such an array may be defined in terms of a number of rows and lines, wherein the position of each component carrier or each preform may be determined by a respective row and/or line.

The above-described embodiment may significantly increase speed and efficiency in the production of component carriers and may thus support mass production of component carriers.

According to an exemplary embodiment, four quarter-panel carrier plates are embedded in the core, wherein all quarter-panel carrier plates may have the same size. Such an embodiment may strike the right balance between stability and reliability of a hybrid core, in particular if the quarter-panel carrier plates are made from glass.

According to a further embodiment of the invention, the at least one carrier plate comprises a release layer at which the stack is removed from the at least one carrier plate.

In the context of the present application, a "release layer" may be configured to detach from an adjacent layer during the manufacture of a component carrier. It may define an interface between a sacrificial structure, e.g. a sacrificial carrier, and the component carrier or a preform of the component carrier. The release layer may define a detachable interface, at which two adjacent layers are detachable from each other, in particular easily detachable by mechanical force. Both adjacent layers may be defined as release layers. Both adjacent layers or only one of them may form part of the carrier plate. The release layer may or may not be an outermost layer of the carrier plate. The release layer may be or comprise a metal layer or an inorganic layer.

A corresponding release layer and/or detachable interface may form part of the core or the core may lack a corresponding release layer and/or detachable interface. In other words, the release layer may extend to other parts of the hybrid core, e.g. the core and/or a gap between core and carrier plate. For example, the release layer may be or comprise an adhesive, in particular a hardened adhesive with which the core is attached to the carrier plate. The release layer may be provided separately from the carrier plate.

Integrating a release layer into the carrier plate may facilitate the removal of the carrier plate from the stack, when the carrier plate is no longer needed for the manufacture of the component carrier.

According to a further embodiment of the invention, the at least one carrier plate comprises a seed layer. The seed layer may be configured to facilitate the formation of the stack on the at least one carrier plate.

In the context of the present application, a "seed layer" may be any layer or layer structure suitable for building one or more layer structures of a component carrier thereon. The seed layer may be an outermost layer of the carrier plate. The seed layer may or may not form part of the stack of the finished component carrier. It may be configured to remain as part of the stack, when the carrier plate is removed from the stack. For this, it may be arranged outward from a release layer of the carrier plate. In a semi-finished product, the seed layer may be arranged closer to the stack compared with the release layer. The seed layer may be a metal layer, in particular a copper layer. It may be configured as a seed layer for a plating step, for example electroplating.

Integrating such a seed layer into the carrier plate may facilitate the formation of layer structures on the carrier plate, in particular layer structures of the component carrier.

According to an exemplary embodiment, the at least one carrier plate comprises a metal layer on at least one of its two opposing main surfaces. This metal layer may be or may comprise the seed layer.

According to an exemplary embodiment, the metal layer, in particular the seed layer, and/or the release layer are formed by sputtering. Sputtering may be a particularly efficient process to apply a metal layer, a seed layer and/or a release layer.

According to an exemplary embodiment, the seed layer is provided separately from the carrier plate and/or extends to other parts of the hybrid core, e.g. the core and/or a gap between core and carrier plate,

According to a further embodiment of the invention, the stack is configured as a redistribution layer, in particular for a component mounted or mountable to the stack. The redistribution layer may consist of or comprise one or more electrically conductive layer structures and/or one or more electrically insulating layer structures. The redistribution layer may be configured to rearrange the electrical contacts of the component, e.g. for more efficient and/or more reliable electrical contacting of the component. Alternatively or additionally, the redistribution layer may be configured to enlarge a footprint of the component, e.g. so that thermal stress is reduced and/or that the quality of electrical signals is improved. Further alternatively or additionally, the redistribution layer may be configured to enlarge the contact area of at least one electrical contact of the component, e.g. so that solder balls, copper pillars or other specific means for electrical contacting of the component can be applied.

The above-described embodiment may be advantageous because component carriers, which serve as thin redistribution layers, may be produced in a simple manner and at low cost by using a hybrid core.

According to a further embodiment of the invention, the redistribution layer enlarges the footprint of the component. A "footprint" of a component may be defined as the surface area of the component comprising electrical contacts for externally connecting the component, in particular a continuous and simply connected surface area, in particular on a given side of the component. The footprint of the redistribution layer may be defined as the surface area of the redistribution layer comprising electrical contacts for externally connecting the component, when the component is attached and electrically connected to the redistribution layer. This surface area may form part of a main surface of the redistribution layer opposite the main surface where the component is attached. The footprint of the redistribution layer may be larger than the footprint of the component, in particular at least ten percent larger, in particular at least fifty percent larger, in particular at least twice as large. When the footprint is enlarged, the contact area, i.e. the exposed surface area, of at least some of the electrical contacts of the component may be enlarged as well. With an enlarged footprint, the density of electrical contacts may be decreased.

Enlarging the footprint may allow for an effective fanout. It may allow for effectively electrically connecting the component, while at the same time enabling further miniaturization of components and/or of electronic packages comprising components. It may improve the quality/integrity of electrical signals, reduce thermal stress and/or enable the use of conventional solder balls, copper pillars or other conventional means for contacting the component.

According to a further embodiment of the invention, the at least one carrier plate is or comprises a glass plate. In particular, a base layer of the carrier plate may consist of or comprise glass. The glass plate may consist of or comprise soda-lime glass.

Using a glass plate may be advantageous because glass may provide a relatively flat and/or smooth surface. It may provide good dimensional stability, in particular for the formation of component carriers such as redistribution layers and/or for the assembly of components to component carriers. Glass plates may be particularly advantageous in a hybrid carrier, because the core of the hybrid carrier may counteract the tendency of glass to break. Furthermore, several glass plates rather than a single glass plate may be advantageous in a hybrid core, because a smaller size of the glass plates may also counteract the tendency of glass to break. Finally, glass may be a comparably cheap material.

According to a further embodiment of the invention, the at least one carrier plate is or comprises a ceramic plate. In particular, a base layer of the carrier plate may consist of or comprise a ceramic material. Ceramic may be a suitable material for a carrier plate, because it may be particularly hard, heat-resistant and/or corrosion-resistant. However, ceramic may also have a tendency to break under strain, e.g. when component carriers are manufactured on the ceramic plate. This tendency to break may be counteracted by using a hybrid core.

According to a further embodiment of the invention, the at least one carrier plate is or comprises a plastic plate, in particular a plastic plate made of polytetrafluoroethylene (PTFE, Teflon®) or polyether ether ketone (PEEK). In particular, a base layer of the carrier may consist of or comprise a plastic. The use of plastic as a material for the carrier plate may be advantageous because plastic may be light-weight, durable and/or cheap to produce. Teflon and PEEK may both be particularly robust, e.g. heat-resistant and/or corrosion-resistant. The material properties of the plastic plate may adequately complement properties of the core, e.g. the mechanical stability provided by the core.

According to a further embodiment of the invention, the at least one carrier plate, in particular a base layer and/or a seed layer of the carrier plate, has a surface roughness Ra of not more than 450 nm, in particular not more than 300 nm, in particular not more than 100 nm, in particular not more than 50 nm. The surface roughness of the seed layer may correspond to the surface roughness of the base layer, e.g. because the seed layer is arranged on the base layer. A surface roughness of less than 300 nm may be suitable for making fine patterns on the carrier plate, e.g. of an order of magnitude line/space = 10/10 $\mu$m. A surface roughness of less than 100 nm may be suitable for making fine patterns of an order of magnitude line/space = 5/5 $\mu$m. A surface roughness of less than 50 nm may be suitable for making fine patterns of an order of magnitude line/space = 3/3 $\mu$m. By contrast, laminating bonding material such as prepreg or an epoxy-based build-up film on the carrier plate may require a surface roughness of at least 300 nm of the carrier plate.

The "roughness" of a surface quantifies the extent to which the surface deviates from its ideal form. Any deviations are usually analyzed in direction of the normal vector of the surface and are characterized by an amplitude, i.e. the height or length of the deviations in surface normal direction, and by a frequency, denoting the amount or number of deviations per surface area. Surface roughness correlates with friction between interacting rough surfaces, if they are moved relative to each other.

One of the most common roughness parameters is Ra, which is the arithmetic average of the absolute values of surface deviations from a mean surface profile. The unit of the roughness parameter Ra is length and it is typically measured in micrometers or nanometers. The mean surface profile may be filtered from the raw surface profile, i.e. the measured surface profile, e.g. by eliminating a waviness component of surface deviations.

Roughness Ra may thus be calculated as

$$Ra = \sum_{m=1,...,M} \sum_{n=1,...,N} |z(x_m, y_n) - \langle z \rangle| / MN$$

with

$$\langle z \rangle = \sum_{m=1,...,M} \sum_{n=1,...,N} z(x_m, y_n) / MN.$$

Here, the sampling points $(x_m, y_n)$ are equally spaced in directions x and y, which span the plane of the examined surface, and z is the direction normal to the examined surface. Thus, $z(x_m, y_n)$ denotes the surface deviation from the mean surface profile in direction of the surface normal at sampling point $(x_m, y_n)$. M and N determine the evaluation length in x-direction and in y-direction, respectively.

Such an embodiment may be advantageous because a smooth surface may allow for an especially accurate formation of further layers on the base layer of the carrier plate, e.g. of a release layer and/or a seed layer, and/or for an especially accurate build-up of layer structures of the stack on the carrier plate. It may result in a corresponding surface of the stack, which is also smooth, in particular has approximately the same roughness as the roughness of the carrier plate. Thereby, the signal integrity of a component carrier, e.g. a redistribution layer, may be increased. The embodiment may also allow for thinner component carriers.

According to a further embodiment of the invention, the at least one carrier plate has a thickness of at least 0.5 mm, in particular of at least 1 mm. Such a thickness may be sufficient to provide appropriate stability for the manufacturing of component carriers and/or to prevent the carrier plate from breaking, in particular if the carrier plate consists of or comprises glass.

According to a further embodiment of the invention, the method comprises surface mounting a component on the stack before removing the at least one carrier plate. Such an embodiment may be advantageous because the hybrid carrier and/or the carrier plate may provide stability during the mounting process.

According to a further embodiment of the invention, the method comprises overmolding the component before removing the at least one carrier plate. Such an embodiment may be advantageous, because the handling of the component carrier may be easier, when it is still attached to the hybrid carrier and/or the carrier plate, in particular with respect to the mentioned overmolding.

According to a further embodiment of the invention, the method comprises exposing part of an electrically conductive layer on the at least one carrier plate by patterning an electrically insulating layer on the electrically conductive layer.

The electrically conductive layer may be a seed layer. The electrically insulating layer may be an insulating film, in particular made from epoxy-based build-up film (EBF). Such an insulating film may be advantageous because it is more easily applied e.g. in comparison with ink-type insulating layers. The electrically insulating layer may comprise at least one of an organic epoxy resin, a hardener, and an inorganic, microparticle filler.

The electrically insulating layer and the hybrid carrier, in particular the carrier plate, may have a similar coefficient of thermal expansion (CTE). For example, the CTEs may deviate by not more than ten percent. A hybrid carrier and/or corresponding carrier plates may be especially suited to provide a carrier with a suitable CTE, which may in turn prevent warpage during manufacture of the component carriers.

According to a further embodiment of the invention, the method comprises applying electrically conductive material selectively on the exposed part of the electrically conductive layer. This step, e.g. an electroplating step, may be advantageous for forming vias in the electrically insulating layer.

According to a further embodiment of the invention, the at least one carrier plate is a glass plate.

According to a further embodiment of the invention, a seed layer is provided on the at least one carrier plate.

According to a further embodiment of the present invention, the seed layer has a thickness smaller than 0.6 $\mu$m.

A seed layer with a thickness smaller than 0.6 $\mu$m improves the formation of the stack on the at least one carrier plate.

According to a further embodiment of the present invention, the at least one electrically insulating layer structure comprises at least one of the group of an EBF layer structure, a PID layer structure, a further EBF layer structure and an SR layer structure.

A PID layer structure or an SR layer structure are advantageous, as they allow an easier patterning of the electrically insulating layer structure by known means.

According to a further embodiment of the invention, a semifinished product comprises the above-described hybrid core and a stack, in particular a stack of the component carrier, on the at least one carrier plate, wherein the stack comprises at least one electrically conductive layer structure and/or at least one electrically insulating layer structure. In the context of the present application, a "semi-finished product" may be a product at any intermediary manufacturing stage. It may or may not comprise elements, which do not form part of the finished product. The semi-finished product may be suitable for storage and/or transport. It may be a product at a manufacturing stage, where the product is particularly stable, e.g. to be stored, transported and/or sold.

In the following further considerations are presented which may be relevant at least for some embodiments of the invention:

In an embodiment, the component carrier is shaped as a plate. This may contribute to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connection. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylether PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay could be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al2O3) or aluminum nitride (AlN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga2O3), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

Some embodiments have been described with reference to apparatus type claims whereas other embodiments have been described with reference to method type claims. However, a person skilled in the art will gather from the above and the following description that, unless otherwise indicated, any combination of features relating to method type claims with features relating to apparatus type claims is disclosed with this document, both with respect to the apparatus as well as with respect to the method.

The aspects defined above and further aspects of the present invention are apparent from the examples of embodiment to be described hereinafter and are explained with reference to the examples of embodiment.

Brief Description of the Drawings

Figure 1 shows a cross-sectional side view of a semifinished product comprising a stack attached to a hybrid core according to an exemplary embodiment of the invention.

Figure 2 shows a layered structure of a carrier plate according to an exemplary embodiment of the invention.

Figure 3 shows a top view of a hybrid core according to an exemplary embodiment of the invention.

Figures 4 to 6 each show a component carrier, which has been manufactured using a method according to an exemplary embodiment of the invention.

Figures 7 to 33 show structures obtained during manufacture of a component carrier using a hybrid core according to an exemplary embodiment of a method of manufacture.

Figures 34 and 35 illustrate a step of bonding a core to a carrier plate according to an exemplary embodiment of the invention.

Figures 36 and 37 illustrate a step of bonding a core to a carrier plate according to an exemplary embodiment of the invention.

Figure 38 shows a cross-sectional side view of an interface between a core and a carrier plate according to an exemplary embodiment of the invention.

Figure 39 shows a cross-sectional side view of a hybrid carrier according to an exemplary embodiment of the invention.

Detailed Description

The illustrations in the drawings are schematic. In different drawings, similar or identical elements are provided with the same reference signs. For the sake of clarity and comprehensibility, reference signs are sometimes omitted for those features, for which reference signs have already been provided in earlier figures.
Before, referring to the drawings, exemplary embodiments will be described in further detail, some basic considerations will be summarized based on which exemplary embodiments of the utility model have been developed.
A fundamental idea of the invention is to provide a carrier plate, in particular a glass carrier, for chip last fan-out panel level packaging (FOPLP), wherein present substrate processes and formats can be used. As an example, a HRDP glass core from Mitsui Co. could be used to this purpose. For each quadrant of the panel, a separate carrier plate could be used, wherein the carrier plates are embedded in a core, in particular a FR4 core. One or more redistribution layers (RDL) are prepared on the carrier plate using a present or conventional substrate process. This is used for packaging assembly. After component or die assembly and mold process, i.e. overmolding of the component, the carrier plate is detached and a seed metal layer on the detached side is recessed to expose a metal ball grid array (BGA) pad. Surface finishing, e.g. organic solderability preservative (OSP) finish, is applied after the recessing. Finally, each assembled unit is singulated. Also, another component or die could be assembled on the detached side to bridge die to die. This may provide more design freedom for system-in-package (SIP) configuration.
For example, glass may be considered to be a promising material for manufacturing redistribution layers. Glass may provide a relatively flat and smooth surface with good dimensional stability during thin redistribution layer processing and assembly. However, glass panels may not be applicable in present substrate processing, e.g. conventional FR4 substrate process such as an SAP process, because glass easily breaks. To profit from the advantages of glass as a carrier, while still employing conventional substrate processes, a glass carrier plate embedded in a core could be used. One or more thin redistribution layers for chip / component last FOPLP may be achievable in this way.

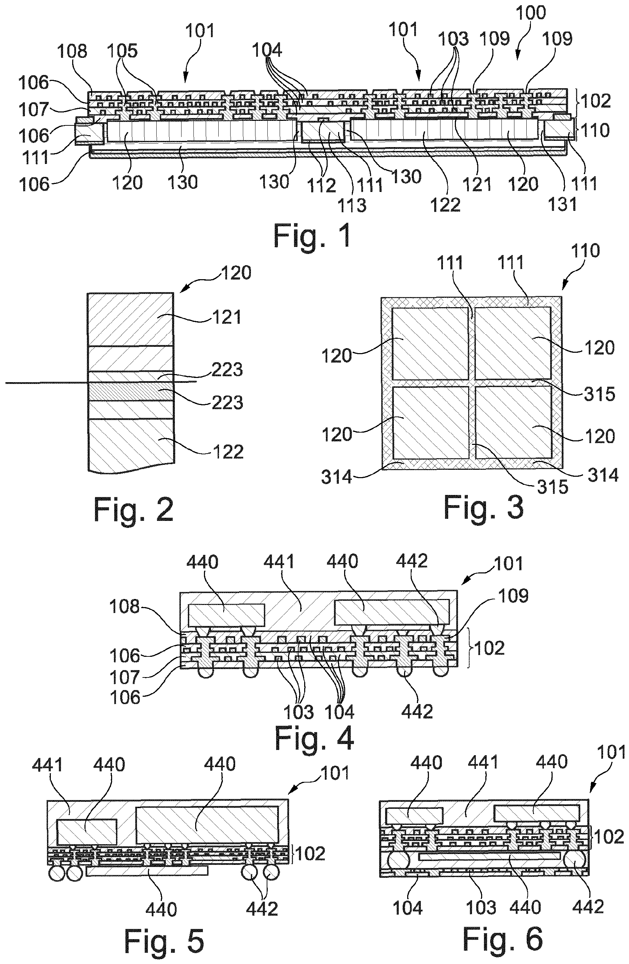

**Figure 1** shows a cross-sectional side view of a semifinished product 100 for manufacturing a component carrier 101. The semifinished product comprises a hybrid core 110 having a core 111 and having two carrier plates 120 embedded in the core 111. The semifinished product 100 also comprises a stack 102 on both carrier plates 120, wherein the stack 102 comprises a plurality of electrically conductive layer structures 103 and a plurality of electrically insulating layer structures 104.
In the hybrid core 110, small gaps 131 are formed between the core 111 and the carrier plates 120. These gaps 131 are filled with an adhesive 130 in order to attach the carrier plates 120 to the core 111. The core 111 consists of a core base layer 113 having a respective core metal layer 112 attached to each of the main surfaces of the core base layer 113. Each of the carrier plates 120 consists of a base layer 122 to which a seed layer 121 is attached at the side of the base layer 122 on which the stack 102 is arranged. Beneath the hybrid core 110, one or more electrically conductive layer structures 103 and/or one or more electrically insulating layer structure 104 may be arranged, for example an epoxy-based build-up film (EBF) layer 106 and a metal layer.

The stack 102 is formed continuously over the whole hybrid core 110. In the order in which the stack 102 is arranged on the carrier plate 120, the stack 102 comprises an EBF layer structure 106, a PID (photoimageable dielectric) layer structure 107, a further EBF layer structure 106, and an SR (solder resist) layer structure 108. Between those electrically insulating layer structures 104, respective electrically conductive layer structures 103 are arranged. Furthermore, the electrically conductive layer structures 103 are connected by vias 105 extending through the electrically insulating layer structures 104. At the top of the stack electrical contacts 109 are exposed in an electrically insulating layer structure 104, here the SR layer structure 108. From the stack 102, component carriers 101 will eventually be singulated. The electrical contacts 109 may be used for contacting a component mounted to the stack 102 or component carrier 101.

**Figure 2** shows the layered structure of a carrier plate 120. On a base layer 122, several de-bonding function layers are arranged, which include one or more release layers 223. Specifically, in the order, in which they are arranged on the base layer 122, the de-bonding function layers comprise first a metal layer, then a further metal layer, which serves as a first release layer 223, and finally an inorganic layer, which serves as a second release layer 223. Between the first and second release layers 223, a releasing interface is arranged indicated by the horizontal black line.

On the de-bonding function layers, one or more seed function layers are arranged. The seed function layers include a seed layer 121, which may be made of copper and may for example be 0.3 $\mu$m thick. The seed function layers may also include a titanium layer of e.g. 0.1 $\mu$m thickness. The seed layer 121 may extend over one or more of the side surfaces of the carrier plate 120 laterally covering the whole stack of de-bonding function layers and seed function layers as well as part of the base layer 122 (not shown). Such a side edge of the seed layer may attach the various function layers to the base layer 122. Only when the side edge is removed, may the seed layer 121 be detachable from the base layer 122 at the releasing interface.

The base layer 122 may be a glass panel. The de-bonding function layers and the seed function layers, in particular the release layers 223 and the seed layer 121, may be applicable to the base layer 122 by sputtering. These function layers may have a total thickness of 0.6 $\mu$m, in particular less than 0.6 $\mu$m.

**Figure 3** shows a hybrid core 110 comprising four rectangular carrier plates 120. The carrier plates 120 are embedded in a core 111 such that ridges 315 of the core 111 separate the carrier plates 120 from each other and such that an outer frame 314 of the core 111 surrounds the carrier plates 120. As a result, each carrier plate 314 forms a quarter panel of the hybrid core 110.

**Figures 4 to 6** each show a component carrier 101, which has been manufactured according to an exemplary embodiment of the invention. Components 440 have been attached to a stack 102 comprising electrically conductive layer structures 103 and electrically insulating layer structures 104. The electrically insulating layer structures 104 comprise an EBF layer structure 106, a PID layer structure 107, a further EBF layer structure 106, and an SR layer structure 108. Electrical contacts 109 are exposed in the SR layer structure 108. Solder balls 442 electrically connect the electrical contacts 109 with components 440, which are mounted to the stack 102. The components 440 are encapsulated by an overmolding 441.

By the methods described in this patent application, various electronic packages comprising a stack 102 and one or more components 440 may be built. For example, on the main surface of the stack 102 opposite the component(s) 440, solder balls 442 may be applied for electrically contacting the package. Also, a further component 440 may be mounted beneath the package. This further component may also be encapsulated by an overmolding 442. Further electrically conductive and/or electrically insulating layer structures 103, 104 may be arranged beneath the package.

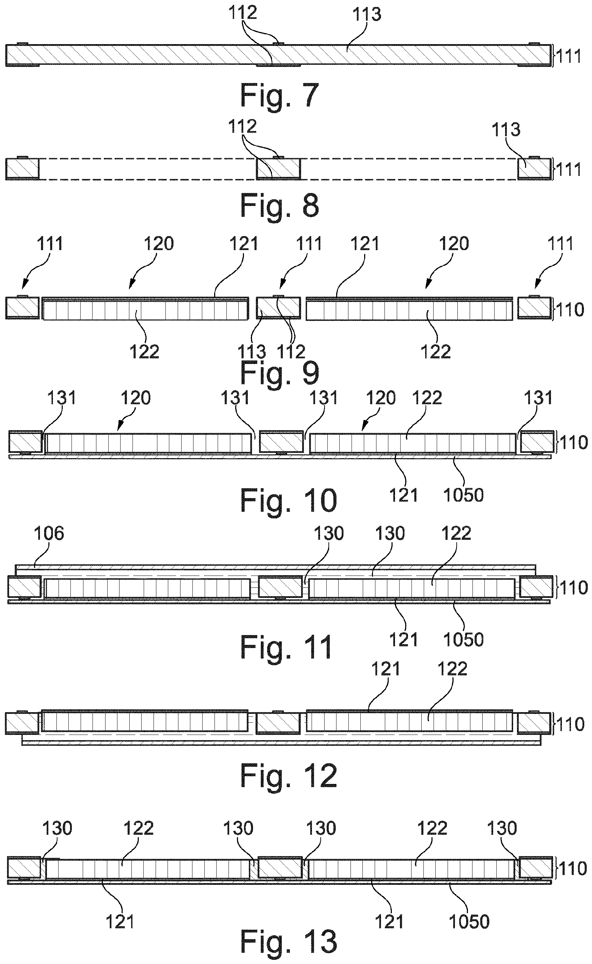

**Figures 7 to 33** show structures obtained during manufacture of a component carrier using a hybrid core 110.

In Figure 7, a core 111 of 1.0 mm thickness is provided. The core 111 comprises a core base layer 113 with a respective core metal layer structure 112 attached to each main surface of the core base layer 113. In Figure 8, through-holes are routed in the core. In Figure 9, a respective carrier plate 120, e.g. a glass carrier with a metal layer 121 attached to one side, is arranged in each of these through-holes. Thereby, a hybrid core 110 is formed. In Figure 10, a temporary carrier 1050, e.g. a carrier tape, is attached to the hybrid core 110, in particular the core 111 and the carrier plates 120, with the metal layer 121 facing and/or adjacent to the carrier tape 1050. Gaps 131 result between core 111 and the carrier plates 120.

In Figure 11, a layer comprising an adhesive substance 130 such as a prepreg layer is applied to the side of the hybrid core 110 opposite the side with the carrier tape 1050. The layer is molded and cured such that the adhesive 130 of the layer, in particular resin, fills the gaps 131 and attaches the carrier plates 120 to the core 111. An EBF layer structure 106 is arranged on the layer comprising the adhesive 130. In Figure 12, the temporary carrier 1050 is removed after the adhesive 130 has been cured.

As an alternative to the process depicted in Figures 11 and 12, the adhesive 130 is applied not in terms of a layer, but in terms of a liquid, which is directly injected into the gaps 131 and is then cured. Again, the temporary carrier 1050 is removed, once the adhesive 130 has been cured.

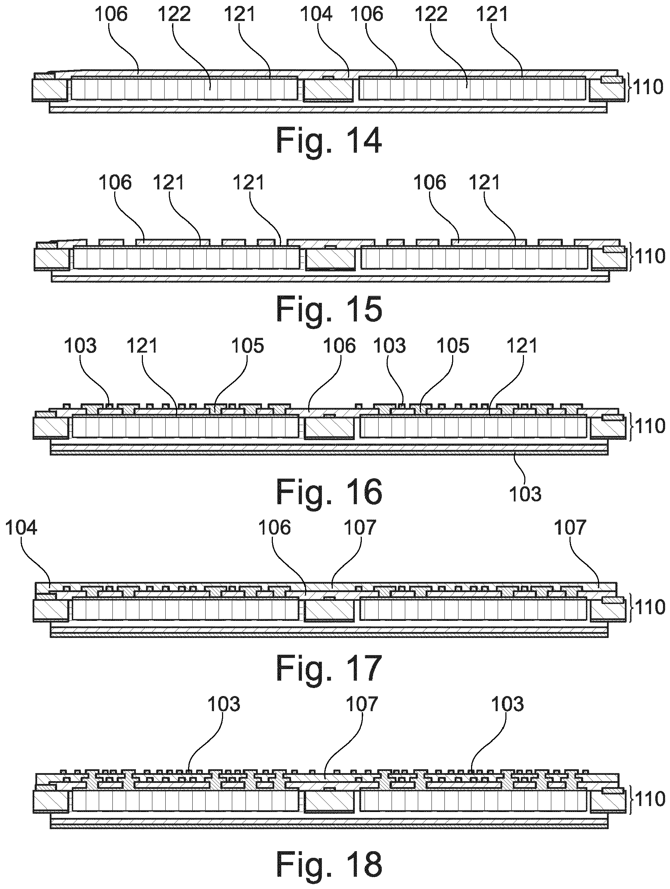

The step depicted in Figure 14 continues the process of Figures 11 and 12 or the process of Figure 13. An insulating layer structure 104, in particular an EBF layer structure 106, is attached, in particular laminated, to the hybrid core 110, in particular to the core 111 and the carrier plates 120, with the metal layer 121 facing and/or adjacent to the EBF layer structure 106. The EBF layer structure 106 may be laminated on top of the metal layer 121. The EBF layer structures 106 on opposite sides of the hybrid core 110 may be laminated subsequently or both at the same time.

In Figure 15, holes are drilled, in particular laser drilled, through EBF layer structure 106 so that the metal layer 121 underneath can be contacted, e.g. for forming a ball grid array (BGA). Alternatively, instead of the EBF layer structure a photoimageable dielectric (PID) may be used and vias may be formed by a lithographic process. In Figure 16, an electrically conductive layer structure 103 is formed on the EBF layer structure 106. Also, the holes are at least partially filled with an electrically conductive material, e.g. copper, so that vias are formed for electrically contacting the metal layer 121 from the electrically conductive layer structure 103. As a result, a first redistribution layer is formed. In Figures 17 to 19, this process is repeated twice, whereby two further redistribution layers are formed. The electrically insulating layer structure 104 may for example be a PID layer structure 107 or a further EBF layer structure 106. A PID layer structure 107 may be laminated and/or coated.

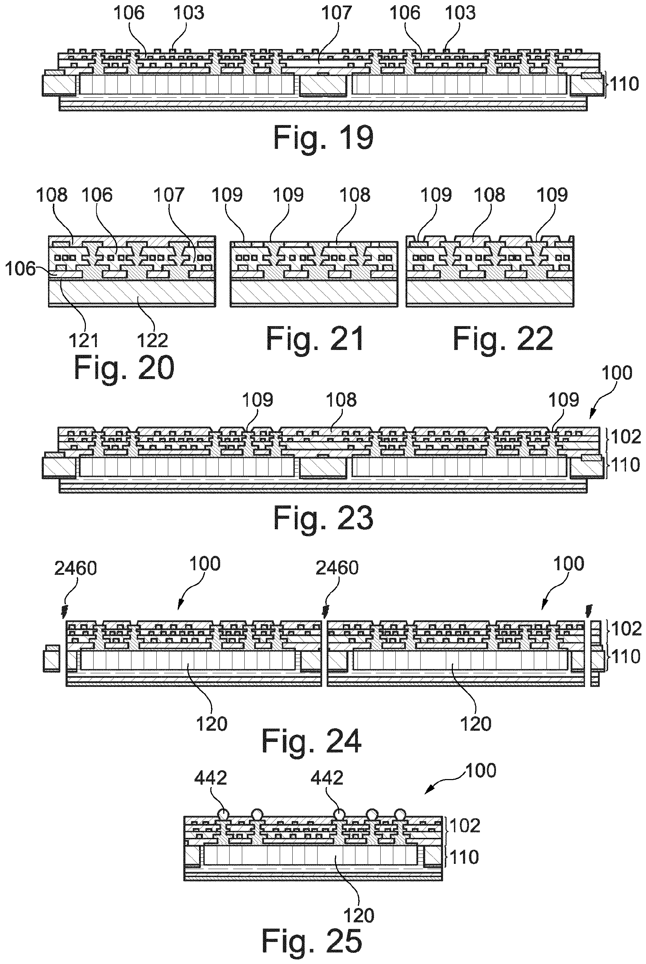

The steps of Figures 20 to 22 show the formation of an image for die connection using a solder resist layer structure 108. Alternatively, a PID layer structure could be used. In Figure 20, a solder resist (SR) layer structure 108 is applied to the stack, in particular by lamination. Electrical contacts 109 can be formed by a plasma etch step as shown in Figure 21. Alternatively, electrical contacts 109 can be formed by lithographic imaging of the SR layer structure 108 as shown in Figure 22. The electrical contacts 109 may be exposed by forming holes through the SR layer structure 108. Subsequently, a surface finished may be applied (not shown), e.g. an ENEPIG surface finish.

Figure 23 depicts a resulting semifinished product 100 with a stack 102 attached to a hybrid core 110. In Figure 24, different portions of the hybrid core 110 and corresponding portions of the stack are separated from each other by a routing step 2460. The hybrid core 110 is separated in regions, where the core 111 is located, rather than in regions, where the carrier plates 120 are located. Each portion of the hybrid core 110 comprises a single carrier plate 120 and surrounding parts of the core 111. This process results in semifinished products 100 as depicted in Figure 25, one for each carrier plate 120. These semifinished products 100 comprise a single carrier plate 120 and a stack 102 built on the carrier plate. Solder balls 442 are mounted on the electric contacts 109.

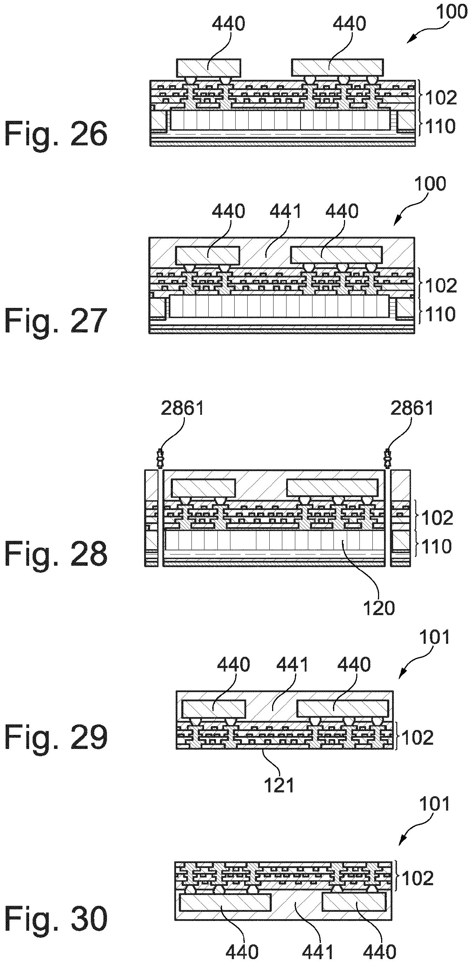

Figure 26 shows the semifinished product of Figure 25 having two components 440 mounted to the stack 102 and electrically connected to the stack 102 by means of the solder balls 442, in particular using bumps and an underfill. In the step of Figure 27, the components 440 are at least partially encapsulated by an overmolding 441. The overmolding 441 attaches directly to the stack 102 providing further stability.

In the step of Figure 28, all regions of the semifinished product 100 of Figure 27, where the core 111 is located are removed by cutting 2861, in particular by laser cutting and/or saw cutting, such that only regions with the carrier plate 120 remain. In the step of Figure 29, the carrier plate 120 is separated from the stack 102. It may for example be separated at a release layer 223 (not shown) or a releasing interface of the carrier plate 120. The releasing may be possible because the core 111 has been cut off, which does not comprise a release layer 223 or a releasing interface.

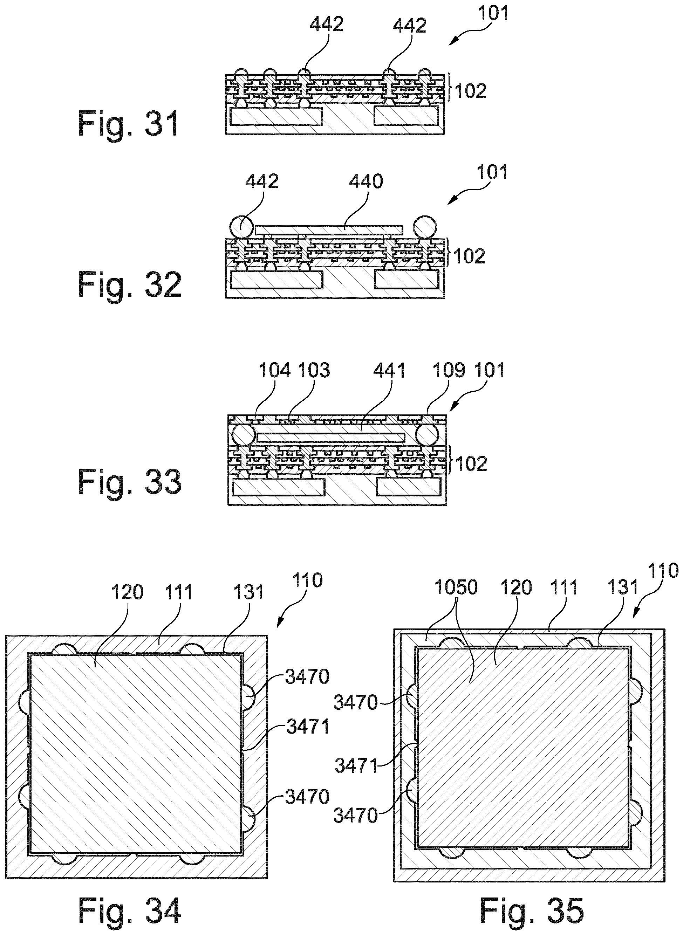

Figure 30 shows a component carrier 101 or an array of component carriers 101, where the metal layer 121, in particular a Ti/Cu layer of the carrier plate 120, has been etched. An array of component carriers 101 may now or at a later step be singulated, i.e. separated into single component carriers 101. In the step of Figure 31, solder balls 442 or alternatively copper pillars have been attached for top side structuring. Also, an organic solderability preservative (OSP) may be applied. In the step of Figure 32, a further component 440 may be attached at a side of the component carrier opposite the side, where components were previously attached. Also, further solder balls 442 or copper pillars may be arranged to contact the component carrier. In particular, TCP bonds may be implemented. Finally, in the step depicted in Figure 33, upper side structuring may be carried out. For example, the further component 440 may be encapsulated by a further overmolding 441. Also, further electrically conductive layer structures 103 and/or further electrically insulating layer structures 104 may be applied. Redistribution layers may be formed on the upper side, i.e. the side, on which the carrier plate was previously attached. Electrical contacts 109 may be formed on the upper side. By this process compact packages comprising electronic components may result.

**Figures 34 to 38** show two processes how a hybrid core 110 may be assembled from a core 111 and at least one carrier plate 120.

The first bonding method as depicted in Figures 34 and 35 shows adhesive filling, in particular resin filling (cp. also Fig. 13). First, a step of direct dispensing of an adhesive such as a mold resin or an epoxy resin is carried out and second, a step of capillary filling is carried out. Figure 34 shows a top view of a hybrid core 110 and Figure 35 a bottom view of the same hybrid core 110. In the bottom view, a temporary carrier 1050, in particular a carrier tape, is visible, to which the core 111 and the carrier plate 120 are attached. The carrier tape 1050 may seal the gaps 131 between core 111 and carrier plate 120 from beneath during assembly of the hybrid core. In the top view of Figure 34, dispensing holes 3470 are visible, in which the adhesive is dispensed. Pins 3471 may guide and/or obstruct the flow of the adhesive. The adhesive then fills at least partially, in particular fully, the gaps 131 and/or capillaries between the carrier plate 120 and the core 111. The width of the gaps and/or capillaries may be between 0.01 and 0.20 mm.

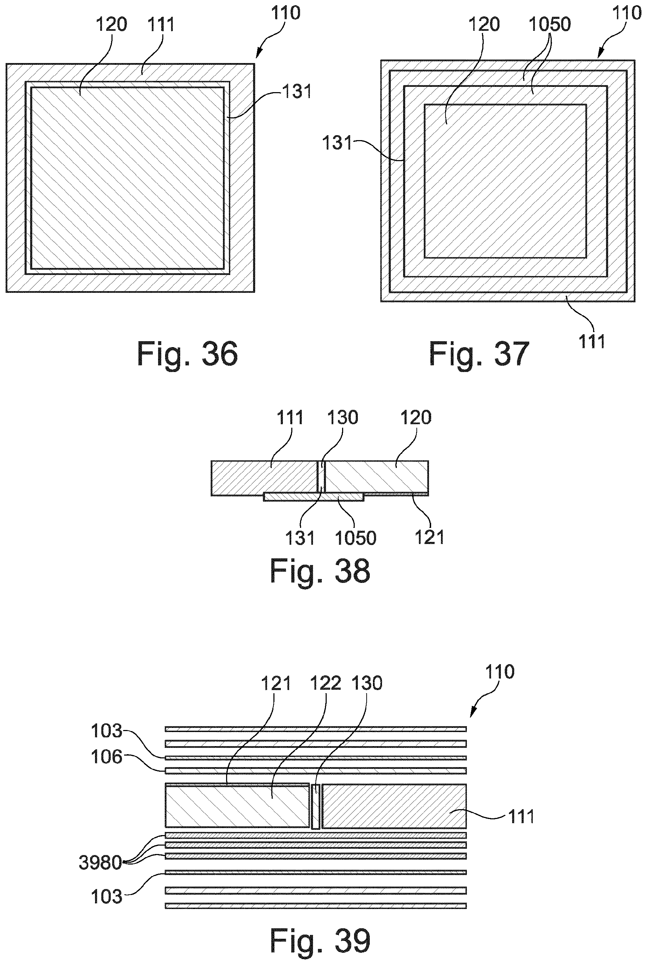

The second bonding method as depicted in Figures 36 to 38 shows adhesive inserting, in particular prepreg inserting (cp. also Figs. 11 and 12). A layer comprising an adhesive 130, e.g. a prepreg layer, is laminated on top of the hybrid core, wherein the gap 131 between core 111 and carrier plate 120 is at least partially, in particular fully, filled with adhesive 130. When the adhesive is cured, the carrier plate 120 is attached to the core 111.

Figure 36 shows a top view of the hybrid core 110 with a gap 131 separating core 111 and carrier plate 120. Figure 37 shows a bottom view of the hybrid core 110 with a carrier tape 1050 attached to the bottom of at least part of the hybrid core 110, in particular attached to both core 111 and carrier plate 120 at a region where the gap 131 is located. The carrier tape 1050 may be an epoxy/glass fabric impregnated tape and it may be approximately 80 $\mu$m thick. It may seal the gap 131 from beneath during assembly of the hybrid core 110.

Figure 38 is a cross-sectional side view of a region of the hybrid core 110, where a gap 131 is located. The gap 131 separates the core 111 from the carrier plate 120 and is filled with adhesive 131. The width of the gap 131 may be between 0.1 mm and 0.2 mm, in particular 0.10 mm, 0.12 mm or 0.14 mm. The carrier tape 1050 is attached to core 111 and carrier plate 120 at the region of the gap 131 and at the side of the carrier plate 120 with the metal layer 121.

**Figure 39** depicts a cross-sectional view of layers of a hybrid core 110 which are to be connected to a stack-up by lamination, in particular by hot press. In the center, a core 111, e.g. a FR-4 core of 1.05 mm thickness, is laterally attached to a carrier plate 120 by an adhesive 130. The carrier plate 120 comprises a base layer 122, e.g. a glass core of 1.0 mm thickness, and a seed layer 121, in particular a metal layer, attached to the base layer 122. On the side, where the seed layer 121 is located, further layers are attached in the following order: an EBF layer 106 of 20 $\mu$m thickness, an electrically conductive layer 103, e.g. a copper foil, a sus plate, i.e. a plate made from stainless steel, and a cushion pad. On the opposite side, i.e. where the seed layer 121 is not located, further layers are attached in the following order: three prepreg layers 3980, an electrically conductive layer 103, e.g. a copper foil, a sus plate, i.e. a plate made from stainless steel, and a cushion pad. The above-described layered structure may be useful for lamination in a hot press.

It should be noted that the term "comprising" does not exclude other elements or steps and the use of articles "a" or "an" does not exclude a plurality. Also, elements described in association with different embodiments may be combined. It should also be noted that reference signs in the claims should not be construed as limiting the scope of the claims.

List of reference signs:

| | |
|---|---|
| 100 | semifinished product |
| 101 | component carrier |
| 102 | stack |
| 103 | electrically conductive layer structure |
| 104 | electrically insulating layer structure |
| 105 | via |
| 106 | EBF layer structure |
| 107 | PID layer structure |
| 108 | SR layer structure |
| 109 | electrical contact |
| 110 | hybrid core |
| 111 | core |
| 112 | core metal layer |
| 113 | core base layer |
| 120 | carrier plate |
| 121 | seed layer |
| 122 | base layer |
| 130 | adhesive |
| 131 | gap |
| 223 | release layer |
| 314 | outer frame |
| 315 | ridge |
| 440 | component |
| 441 | overmolding |
| 442 | solder ball |
| 1050 | carrier tape |

2460 routing
2861 cutting
3470 dispensing hole
3471 pin
3980 prepreg layer

**Claims**

1. A method of manufacturing a component carrier (101), wherein the method comprises:

   embedding at least one carrier plate (120) in a core (111);
   forming a stack (102) on the at least one carrier plate (120), wherein the stack (102) comprises at least one electrically conductive layer structure (103) and/or at least one electrically insulating layer structure (104);
   thereafter removing the at least one carrier plate (120) from the stack (102).

2. The method of claim 1, wherein a plurality of carrier plates (120) are embedded in the core (111).

3. The method of claim 2, wherein two carrier plates (120) of the plurality of carrier plates (120) are separated by a portion (315) of the core (111).

4. The method of any one of the preceding claims, wherein the at least one carrier plate (120) is attached to the core (111) by an adhesive (130), and/or wherein the core (111) and the at least one carrier plate (120) form part of a panel, by means of which a plurality of component carriers (101) can be manufactured, and/or wherein the at least one carrier plate (120) comprises a release layer (223) at which the stack (102) is removed from the at least one carrier plate (120) and/or, wherein the at least one carrier plate (120) comprises a seed layer (121), which is configured to facilitate the formation of the stack (102) on the at least one carrier plate (120).

5. The method of any one of the preceding claims, wherein the stack (102) is configured as a redistribution layer for a component (440) mounted to the stack (102).

6. The method of claim 5, wherein the redistribution layer enlarges the footprint of the component (440).

7. The method of any one of the preceding claims, wherein the at least one carrier plate (120) comprises a glass plate and/or a ceramic plate and/or a plastic plate, and/or wherein the at least one carrier plate (120) has a surface roughness Ra of not more than 450 nm and/or wherein at least one carrier plate (120) has a thickness of at least 0.5 mm.

8. The method of any one of the preceding claims, wherein the method comprises surface mounting a component (440) on the stack (102) before removing the at least one carrier plate (120).

9. The method of claim 8, wherein the method comprises overmolding the component (440) before removing the at least one carrier plate (120).

10. The method of any one of the preceding claims, wherein the method comprises exposing part of an electrically conductive layer (121) on the at least one carrier plate (120) by patterning an electrically insulating layer (106) on the electrically conductive layer (121).

11. The method of claim 10, wherein the method comprises applying electrically conductive material selectively on the exposed part of the electrically conductive layer (121).

12. A hybrid core (110) for manufacturing a component carrier (101), wherein the hybrid core (110) comprises

    a core (111); and
    at least one carrier plate (120) embedded in the core (111),

    wherein the carrier plate (120) is configured so that a stack (102) comprising at least one electrically conductive layer structure (103) and/or at least one electrically insulating layer structure (104) can be formed on the at least one carrier plate (120).

13. The hybrid core (110) of claim 12, wherein a seed layer (121) is applied on the at least one carrier plate (120), wherein it is preferably provided that the seed layer (121) has a thickness smaller than 0.6 $\mu$m.

14. The hybrid core (110) of one of the claims 12 or 13, wherein the at least one electrically insulating layer structure (104) comprises at least one of the group of an EBF layer structure (108), a PID layer structure (107), a further EBF layer structure (106) and an SR layer structure (108).

15. A semifinished product (100) for manufacturing a component carrier (101), wherein the semifinished product (100) comprises

the hybrid core according to one of the claims 12 to 14; and
a stack (102) on the at least one carrier plate (120), wherein the stack comprises at least one electrically conductive layer structure (103) and/or at least one electrically insulating layer structure (104).

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

106   122   121   104  106   122   121

}110

## Fig. 14

106   121   121   106   121

}110

## Fig. 15

103   121   105   106  103   105   121

}110

103

## Fig. 16

104   106   107   107

}110

## Fig. 17

103   107   103

}110

## Fig. 18

106    103                    107    106    103

Fig. 19

⟩110

108  106      107  109   109   108        109   108   109

106

121    122
Fig. 20

Fig. 21         Fig. 22

100

109      108              109
⟩102
⟩110

Fig. 23

2460        100       2460              100

⟩102
⟩110

120        Fig. 24        120

442        442           100

⟩102
⟩110

120
Fig. 25

Fig. 26

Fig. 27

Fig. 28

Fig. 29

Fig. 30

## Fig. 31

442 442 101

102

## Fig. 32

442 440 101

102

## Fig. 33

104 103 441 109 101

102

## Fig. 34

120 111 131 110

3470

3471

3470

## Fig. 35

1050 120 111 131 110

3470

3471

3470

120   111        110

131

Fig. 36

120   1050        110

131

111

Fig. 37

111   130   120

131   1050   121

Fig. 38

121   122   130        110

103

106

111

3980

103

Fig. 39

Europäisches
Patentamt

European
Patent Office

Office européen
des brevets

# EUROPEAN SEARCH REPORT

Application Number

EP 22 16 4202

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/363043 A1 (GOTTWALD THOMAS [DE] ET AL) 28 November 2019 (2019-11-28) | 12-15 | INV.<br>H05K1/03 |
| A | * figures 7-13 *<br>* paragraphs [0048] - [0058] * | 1-11 | H01L23/498<br>H01L23/15 |
| A | US 2016/135292 A1 (LEE JAE-SEOK [KR]) 12 May 2016 (2016-05-12)<br>* figures 1,2,6,7 * | 1-15 | |

TECHNICAL FIELDS
SEARCHED      (IPC)

H01L
H05K

The present search report has been drawn up for all claims

| Place of search | Date of completion of the search | Examiner |
|---|---|---|
| The Hague | 3 October 2022 | Deconinck, Eric |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
....................................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 22 16 4202

This annex lists the patent family members relating to the patent documents cited in the above-mentioned European search report.
The members are as contained in the European Patent Office EDP file on
The European Patent Office is in no way liable for these particulars which are merely given for the purpose of information.

03-10-2022

| Patent document cited in search report | | Publication date | Patent family member(s) | Publication date |
|---|---|---|---|---|
| US 2019363043 | A1 | 28-11-2019 | CN 110517991 A | 29-11-2019 |
| | | | DE 102018207955 A1 | 28-11-2019 |
| | | | US 2019363043 A1 | 28-11-2019 |
| US 2016135292 | A1 | 12-05-2016 | NONE | |

EPO FORM P0459

For more details about this annex : see Official Journal of the European Patent Office, No. 12/82